# EUROPÄISCHE PATENTSCHRIFT

(11) **EP 4 049 048 B1**
(45) Veröffentlichungstag und Bekanntmachung des Hinweises auf die Patenterteilung: **12.02.2025**
(21) Anmeldenummer: 20740227.2
(22) Anmeldetag: 19.06.2020
(51) Int. Cl.: G01R 31/28, G01R 31/311

(54) **WAFER-LEVEL-TESTVERFAHREN FÜR OPTO-ELEKTRONISCHE CHIPS**
WAFER-LEVEL TEST METHOD FOR OPTOELECTRONIC CHIPS
PROCÉDÉ DE TEST SUR TRANCHE POUR PUCES OPTOÉLECTRONIQUES

(30) Priorität: 25.10.2019 DE 102019007516
(43) Veröffentlichungstag der Anmeldung: 31.08.2022
(73) Patentinhaber: JENOPTIK Optical Systems GmbH, 07745 Jena (DE)
(72) Erfinder: GNAUSCH, Tobias, 07743 Jena (DE); GRUNDMANN, Armin, 07743 Jena (DE); KADEN, Thomas, 01097 Dresden (DE); JANUNTS, Norik, 07747 Jena (DE); BÜTTNER, Robert, 07749 Jena (DE); KARRAS, Christian, 07743 Jena (DE)
(74) Vertreter: Gleim Petri Patent- und Rechtsanwaltspartnerschaft mbB
(86) Internationale Anmeldenummer: PCT/DE2020/100521
(87) Internationale Veröffentlichungsnummer: WO 2021/078318

(56) Entgegenhaltungen:
- WO-A1-2019/029765
- JP-A- 2005 351 807
- US-A1- 2005 194 990
- US-A1- 2013 001 405
- US-B1- 7 378 861
- DE COSTER JEROEN ET AL: "Test-station for flexible semi-automatic wafer-level silicon photonics testing", 2016 21TH IEEE EUROPEAN TEST SYMPOSIUM (ETS), IEEE, 23 May 2016 (2016-05-23), pages 1 - 6, XP032928385, DOI: 10.1109/ETS.2016.7519306

## Beschreibung

Die Erfindung betrifft ein Verfahren mit dem in einem Waferprober zeitgleich die Funktionalität von elektrischen und optischen Komponenten bzw. Schaltungen eines Chips auf Wafer - Ebene getestet werden kann. Ein solches Verfahren ist gattungsgemäß aus der US 2011/0279812 A1 bekannt.

Die Erfindung ist im Bereich des Testens und Qualifizierens von Chips mit optischelektrisch integrierten Schaltungen, sogenannten PICs (Photonic Integrated Circuits), auf Wafer-Ebene angesiedelt. Im Unterschied zu herkömmlichen, rein elektrisch integrierten Schaltungen, sogenannten ICs (Integrated Circuits), sind bei PICs neben den elektrischen Schaltungen auch optische Funktionalitäten integriert.

Bei der Herstellung von ICs, z. B. mittels CMOS-Technologie, finden in verschiedenen Herstellungsschritten Tests und Messungen statt, um einerseits den Prozess zu überwachen und andererseits eine Qualitätskontrolle durchzuführen. Ein etablierter Test ist dabei der elektrische Wafer Level Test nach der Fertigstellung des Wafers. Hier werden funktionale und nicht-funktionale Chips ermittelt, in einer Wafermap erfasst und damit die Ausbeute bestimmt. Funktionale Chips werden auch als Known Good Dies (KGD) bezeichnet. Beim Vereinzeln des Wafers in einzelne Chips erfolgt dann das Aussortieren der nicht funktionalen Chips. Die für den Wafer Level Test benötigte Testapparatur steht in Form von Waferprobern und Wafertestern mit zugehörigen Kontaktierungsmodulen (auch Probecards genannt) zur Verfügung. Mittels des Kontaktierungsmoduls werden die geräteseitigen Schnittstellen des Wafertesters mit den individuellen Schnittstellen der Chips des auf dem Waferprober fixierten Wafers verbunden. Grundsätzlich kann das Kontaktierungsmodul so ausgeführt sein, dass es nur einen oder aber auch zeitgleich mehrere Chips kontaktiert. Es ist auch nicht zwingend erforderlich, dass die Chips zur Kontaktierung noch im Waferverbund vorliegen. Um gleichzeitig mehrere oder auch nacheinander die Chips eines Wafers zu kontaktieren, müssen die Chips lediglich eine fixierte und definierte Lage zueinander aufweisen.

Testapparaturen zum Testen rein elektronischer Chips (Halbleiterchip mit ICs) wurden über Jahrzehnte optimiert und diversifiziert, um zur Kostenoptimierung hohe Volumina unterschiedlichster ICs mit hohem Durchsatz qualifizieren zu können.

Die Herstellung der PICs erfolgt i.d.R. mit den gleichen etablierten Halbleiterprozessen, z. B. der CMOS-Technologie. Die bisher im Vergleich zur IC-Herstellung sehr geringen Fertigungsvolumina von PICs führen dazu, dass i.d.R. in einer Halbleiterfabrik nur Tests zur Prozesscharakterisierung, aber keine funktionalen Tests der PICs durchgeführt werden. Die funktionale Charakterisierung obliegt dem Endkunden und wird oft an gesägten Chips durchgeführt. Die benutzte Testapparatur verwendet voneinander unabhängige, getrennte elektrische und optische Kontaktierungsmodule und ist nicht auf Durchsatz optimiert.

Das Testen von PICs auf Wafer-Level-Ebene erfordert das Ein- und Auskoppeln von Licht in die bzw. aus der Ebene der PICs, i.d.R. mittels integrierter Grating-Koppler als Koppelstellen, wie in der Fachliteratur "Grating Couplers for Coupling between Optical Fibers and Nanophotonic Waveguides" (D. Taillaert et al, Japanese Journal of Applied Physics, Vol. 45, No. 8A, 2006, S. 6071-6077) beschrieben. Die Gitterkoppler (Grating Couplers) können funktionaler Bestandteil im Chip oder Opferstrukturen auf dem Wafer z. B. im Ritzgraben oder auf benachbarten Chips sein.

Dem Stand der Technik entsprechend werden glasfaserbasierte Systeme für den Wafer Level Test verwendet, wie in der Fachliteratur: "Test-station for flexible semiautomatic wafer-level silicon photonics testing" beschrieben (J. De Coster et al, 21th IEEE European Test Symposium, ETS 2016, Amsterdam, Netherlands, May 23-27, 2016. IEEE 2016, ISBN 978-1-4673-9659-2). Diese beinhalten ein glasfaserbasiertes Optikmodul, das über einzelne Glasfasern Licht in die Koppelstellen des Chips ein- und auskoppelt. Um eine wiederholgenaue optische Kopplung zu gewährleisten, müssen die Glasfasern zum einen submikrometergenau zu den Koppelstellen in einem Abstand bis zu wenigen Mikrometern justiert werden. Dies ist nur unter Zuhilfenahme hochpräziser Stellelemente möglich, z.B. in Kombination von Hexapoden mit Piezoelementen. Zum anderen muss vor jeder einzelnen optischen Kopplung ein zeitintensiver, aktiver und auf das Erreichen maximaler Koppeleffizienz ausgelegter Justageablauf erfolgen.

Damit sind bestehende Wafer-Level-Test-Systeme gekennzeichnet durch
- sequentielles, zeitintensives Kontaktieren aller optischen Koppelstellen eines Chips nacheinander, d. h. eine parallele Kontaktierung aller optischen Koppelstellen eines Chips ist nicht oder nur stark eingeschränkt möglich, eine parallele Kontaktierung mehrerer Chips gar nicht möglich.
- geräteseitige Sonderlösungen, so dass herkömmliche Waferprober nur mit aufwendigen und kostenintensiven Modifikationen umrüstbar und danach nicht mehr oder nur bedingt bzw. erst nach zeitaufwendiger Umrüstung für den Wafer Level Test von ICs einsetzbar sind.
- getrennte, nicht fest miteinander verbundene Elektronik- und Optikmodule, d. h. beide müssen separat gehaltert und justiert werden.

Aus der vorgenannten US 2006/0109015 A1 ist ein optoelektronisches Kontaktierungsmodul (probe module) zum Testen von Chips (zu untersuchendes Objekt - DUT 140) mit elektrischen und optischen Ein- und Ausgängen bekannt. Das Kontaktierungsmodul stellt eine Schnittstelle zwischen einer Testapparatur (ATE) und dem Testobjekt (device under test, kurz DUT) dar und ist mit elektrischen Kontakten (electical probes), optischen Kontakten (optical probes), optischen Elementen und Kombinationen hiervon ausgeführt, um Signale von dem DUT und zu dem DUT zu leiten und diese Signale umzuverteilen für eine Schnittstelle zur Testapparatur.

Zu den optischen Ein- und Ausgängen ist offenbart, dass diese über optische Elemente geschaffen sind, die sich auf der Kontaktierungsplatte und / oder der Umverteilungsplatte befinden und auf verschiedene Einkoppelmechanismen, z. B. Freistrahlung, Quasifreistrahlung oder Wellenleiter, abgestimmt sind. Als hierfür geeignete optische Elemente sind diffraktive Elemente und refraktive Elemente angegeben. Auch ist angegeben, dass ein Photodetektor oder eine Lichtquelle direkt an der Schnittstelle zum DUT angeordnet sein können, die dann den optischen Ein- oder Ausgang an der Kontaktierungsplatte darstellen.

Darüber hinaus lehrt die vorgenannte US 2006/0109015 A1, dass für Ausführungen der optischen Einkopplung über Freistrahl- oder Quasifreistrahlverbindungen, bei denen das optische Signal durch einen Freiraum zwischen dem optischen Element und der Schnittstelle zum DUT geleitet wird, das optische Signal fokussiert oder kollimiert wird, um eine hohe Einkoppeleffizienz des übertragenen Signals zu erreichen. Die Signaleinkopplung unterliegt hier folglich dem Konzept, das Signal möglichst vollständig einzukoppeln.

Nach einem Ausführungsbeispiel der vorgenannten US 2006/0109015 A1 sind die optischen und die elektrischen Signalleitungen (optisches und elektrisches Verteilernetz) auf separaten Umverteilungsplatten ausgeführt. Es wird vorgeschlagen, die elektrischen Signale von dem DUT zu den Randbereichen der Kontaktierungsplatte zu führen, so dass in der oberhalb der Kontaktierungsplatte angeordneten ersten Umverteilungsplatte die elektrischen Signale oberhalb des Randbereiches eingekoppelt werden. Dadurch kann in der ersten Umverteilungsplatte, in der nur die elektrischen Signale umverteilt werden, eine Öffnung ausgebildet sein, durch die hindurch die optischen Signale in eine darüber angeordnete separate zweite Umverteilungsplatte geführt werden.

Zusammenfassend werden in der vorgenannten US 2006/0109015 A1 eine Vielzahl von Ideen aufgezeigt, wie ein Kontaktierungsmodul, das begründet, z. B. durch den Verschleiß der mechanischen Kontakte für die elektrische Signalübertragung, in eine Kontaktierungsplatte und eine Umverteilungsplatte unterteilt ist, zusätzlich mit optischen Signalleitungen ausgestattet werden könnte. Dabei wird völlig außer Betracht gelassen, dass die für den mechanischen Kontakt der elektrischen Ein- und Ausgänge des Kontaktierungsmoduls zum DUT möglichen Toleranzen nicht auf die optischen Ein- und Ausgänge übertragbar sind.

Während die Übertragung eines stets gleichen elektrischen Signals lediglich einen mechanischen Kontakt von an dem Kontaktierungsmodul vorhandenen Nadeln mit an dem DUT vorhandenen Kontaktplättchen (Kontaktpads) erfordert, was innerhalb einer vergleichsweise großen Lagetoleranz von einigen µm in alle drei Raumrichtungen gesichert werden kann, wird die Qualität der optischen Signalübertragung bereits bei einer sehr viel kleineren, im Sub-µm-Bereich liegenden Abweichung von einer Solllage beeinflusst.

Erfolgt, wie in der vorgenannten US 2006/0109015 A1 beschrieben, eine Optimierung der Koppeleffizienz des optischen Signals durch eine Kollimation oder Fokussierung des optischen Strahls, muss das gesamte Kontaktierungsmodul hochpräzise im Sub-µm-Bereich justiert werden. Andernfalls ist die justageabhängige Wiederholgenauigkeit der Messung nicht ausreichend für die beschriebenen Anwendungen. Das wiederum hat zur Folge, dass das Kontaktierungsmodul nicht die in herkömmlichen elektrischen Waferprobern typischen Justagetoleranzen für die elektrische Kontaktierung im Bereich von einigen Mikrometern in X-, Y- und Z-Richtung ausschöpfen kann. Es werden aufwendige und teure Waferprober-Sonderlösungen u. a. mit diversen Stellelementen, wie zum Beispiel Piezostellelementen, und Linearachsen oder Hexapoden benötigt, um das Kontaktierungsmodul hochgenau zum DUT zu justieren.

Ein weiterer kritischer Punkt ist, dass für die saubere elektrische Justage der Nadeln ein sogenannter Overdrive von typisch einigen 10 µm in Z-Richtung eingestellt wird, d. h. dass nach Erstkontakt der Nadeln mit den elektrischen Kontaktpads das Kontaktierungsmodul noch um einen zusätzlichen Betrag in Z-Richtung verfahren wird, um eine zuverlässige elektrische Kontaktierung zu gewährleisten. Abnutzung und Verformung der Nadeln werden i.d.R. durch eine Anpassung des Overdrives während des Betriebes gegenkompensiert. Bei einer einfachen Kollimation oder Fokussierung des optischen Strahls, wie in der vorgenannten US 2006/0109015 A1 beschrieben, darf für eine wiederholgenaue Kopplung der Arbeitsabstand in Z-Richtung jedoch nur im Bereich um Mikrometer schwanken. Damit ist diese Art der optischen Kopplung nicht kompatibel mit etablierten elektrischen Kontaktierungsverfahren.

Die US 2011/0279812 A1 offenbart ein Kontaktierungsmodul zum Testen von Chips mit elektrischen und optischen Ein- und Ausgängen. Der Chip ist auf einem beweglichen Träger aufgenommen, mit dem er sich grob zum Kontaktierungsmodul ausrichten lässt. Die Grobausrichtung erfolgt sensorgesteuert anhand einer Positionsüberwachung des Chips oder der Justiermarken des Chips. Die Feinausrichtung des Chips erfolgt in zwei Verfahrensschritten. Im ersten Verfahrensschritt wird überprüft, ob die elektrischen Ein- und Ausgänge in Kontakt zum Kontaktierungsmodul stehen. Der Chip wird dazu mit dem Kontaktierungsmodul angesaugt, sodass die elektrischen Ein- und Ausgänge des Chips mit den elektrischen Kontakten des Kontaktierungsmoduls in Kontakt kommen. Mittels eines Testsignals wird auf eine erfolgreiche Kontaktierung geprüft und bei fehlerhafter Kontaktierung mittels einer wiederholten Grobausrichtung korrigiert. Im zweiten Verfahrensschritt erfolgt die Ausrichtung an den optischen Ein- und Ausgängen. Die optischen Ein- und Ausgänge des Chips können fokussierte oder kollimierte Strahlen mit angepasster Apertur und Fokusposition empfangen oder aussenden. Die optischen Ein- und Ausgänge des Kontaktierungsmoduls verfügen über variable Optiken, mit denen senkrecht auf die Oberfläche der optischen Ein- und Ausgänge fokussierte Strahlen erzeugt werden können, wobei die axiale und seitliche Fokuslage und die Apertur der Strahlen anpassbar sind. Für die Anpassung verfügt die variable Optik über mindestens ein optisches Element mit veränderbarer Brennweite und/oder mindestens ein optisches Element, das beweglich ist. Die axiale Anpassung der Fokuslage erfolgt auf Grundlage von Abstandsmessungen mittels zusätzlicher Abstandssensoren oder von Intensitätsmessungen anhand eines optischen Testsignals. Die seitliche Anpassung der Fokuslage erfolgt auf Grundlage von Intensitätsmessungen, bei denen ein bereits auf die Oberfläche des Chips fokussierter Teststrahl in einer scannenden Relativbewegung gegenüber den optischen Ein- und Ausgängen bewegt wird, bis der Teststrahl optimal in die optischen Ein- und Ausgänge eingekoppelt wird. Die dafür benötigte Zeit kann verkürzt werden, indem die scannende Relativbewegung zunächst mit einem vergrößerten Fokusdurchmesser des Teststrahls ausgeführt wird. Nach der Feinausrichtung erfolgt der Test des Chips mittels spezieller elektrischer und optischer Testsignalsequenzen, wobei beim Testen mehrerer gleichartiger Chips Teile der Grob- und Feinjustage abgespeichert und weiter verwendet werden können.

Zum Testen von elektronischen Chips auf Waferebene ist es aus der Praxis bekannt, dass mittels einer ersten Kamera die Raumlage der Spitzen der Nadeln und mit einer zweiten Kamera die Raumlage der Mittelpunkte der Kontaktpads eines Chips bestimmt werden. Aus einer daraus abgeleiteten Relativlage der Spitzen zu den Kontaktpads werden Steuersignale gebildet, mit denen ein Positioniertisch angesteuert wird und die Mittelpunkte der Kontaktpads lotrecht unterhalb der Spitzen positioniert werden, bevor die Kontaktnadeln mit den Kontaktpads in Kontakt gebracht werden. Ein weiteres Verfahren zum Testen von auf einem Wafer angeordneten opto-elektrischen Chips ist in WO 2019/029765 A beschrieben.

Es ist die Aufgabe der Erfindung ein Verfahren zum Testen von auf einem Wafer angeordneten optoelektronischen Chips mit elektrischen Schnittstellen in Form von Kontaktpads und hierzu fest angeordneten optischen Schnittstellen in Form von optischen Umlenkelementen mit einem spezifischen Kopplungswinkel zu finden, das auf bewährten Verfahren zum Testen von elektronischen Chips basiert.

Diese Aufgabe wird mit einem Verfahren zum Testen von auf einem Wafer angeordneten opto-elektronischen Chips mit elektrischen Schnittstellen in Form von Kontaktpads und hierzu fest angeordneten optischen Schnittstellen in Form von optischen Umlenkelementen gelöst. Die optischen Umlenkelemente weisen einen spezifischen Kopplungswinkel auf.

Dabei wird der Wafer von einem in x -, y- und z- Richtung eines kartesischen Koordinatensystems verstellbaren und um die z Achse drehbaren Positioniertisch aufgenommen. Es ist ein Kontaktierungsmodul vorhanden, welches über zu den Chips zugeordnete elektrische Schnittstellen und optische Schnittstellen verfügt und gegenüber dem Positioniertisch verstell- und verdrehbar ist.

In einem ersten Justierschritt wird der Wafer dem Kontaktierungsmodul so zugestellt, dass die an dem Kontaktierungsmodul vorhandenen elektrischen Schnittstellen in Form von Nadeln, in einer ersten Justierlage, lotrecht oberhalb der Mittelpunkte der Kontaktpads eines ersten der Chips angeordnet sind. In dieser ersten Justierlage ist das Kontaktierungsmodul in z-Richtung in einem Justierabstand größer einer freien Länge der Nadeln zu dem ersten der Chips angeordnet, sodass die Nadeln während der nächsten Justierschritte keinen Kontakt zu den Kontaktpads haben

Aus dieser ersten Justierlage heraus erfolgt in weiteren Justierschritten die relative Ausrichtung der optischen Umlenkelemente zu den an dem Kontaktierungsmodul vorhandenen optischen Schnittstellen. Die Kontaktpads sind so dimensioniert, dass die bei den weiteren Justierschritten erforderlichen Stellwege nur so groß sind, dass die Nadel nach einem abschließenden Absenken Kontakt mit den Kontaktpads erlangen.

Es wird in einem Scanfeld kleiner der Größe der Kontaktpads zuerst der Positioniertisch gegenüber der ersten Justierlage in x- und y-Richtung in eine zweite Justierlage ausgelenkt. Währenddessen wird über wenigstens eine der optischen Schnittstellen des Kontaktierungsmoduls und eines der optischen Umlenkelemente ein optisches Signal geleitet wird. Die zweite Justierlage ist dann eingenommen, wenn das optische Signal mit einer maximalen Intensität eingekoppelt wird. Anschließend wird der erste der Chips über einen Stellweg in eine dritte Justierlage in x-y- Richtung ausgelenkt wird, nachdem der Stellweg aus dem Zustellweg und dem Kopplungswinkel des betreffenden optischen Umlenkelementes berechnet wurde.

Anschließend wird der Positioniertisch dem Kontaktierungsmodul in z-Richtung um einen Zustellweg in einen optischen Arbeitsabstand zugestellt, indem die Nadeln mit einer vorgegebenen Andruckkraft an den Kontaktpads anliegen.

Zum Testen des opto-elektronischen Chips werden jetzt über die jeweils einander zugeordneten Schnittstellen elektrische bzw. optische Signale geleitet Vorteilhaft wird eine sich aus der ersten Justierlage und der zweiten Justierlage des ersten der Chips ergebende Lagedifferenz als Offset abgespeichert und für die Justierung weiterer der Chips berücksichtigt, nachdem diese in einer ersten Justierlage zum Kontaktierungsmodul positioniert wurden.

Insbesondere um den Verschleiß der Nadelspitzen zu berücksichtigen, ist es von Vorteil, wenn der optische Arbeitsabstand, bei dem die Nadeln mit einer vorgegebenen Andruckkraft an den Kontaktpads anliegen, überwacht wird und bei Änderungen der Andruckkraft die dritte Justierlage korrigiert wird.

Indem die Änderung des optischen Arbeitsabstandes langfristig über die Einsatzdauer des Kontaktierungsmoduls ermittelt wird, ist es vorteilhaft möglich für die Verfahrensdurchführung die Nadeln des Kontaktierungsmoduls gegen neue Nadeln zu ersetzen, wenn der optische Arbeitsabstand einen vorgegebenen Minimalabstand unterschreitet.

Indem die optischen Signale die jeweilige Schnittstelle beim Einkoppeln vorteilhaft überstrahlen, werden insbesondere Lagetoleranzen der optischen Schnittstellen der Chips untereinander ausgeglichen.

Noch vorteilhafter ist es, wenn die über die jeweils einander zugeordneten Schnittstellen geleiteten optische Signale beim Einkoppeln eine Tophat-Verteilung ihrer Strahlungsintensität aufweisen.

Die Erfindung soll nachfolgend anhand von Ausführungsbeispielen unter Zuhilfenahme von Zeichnungen näher erläutert werden. Hierzu zeigt:

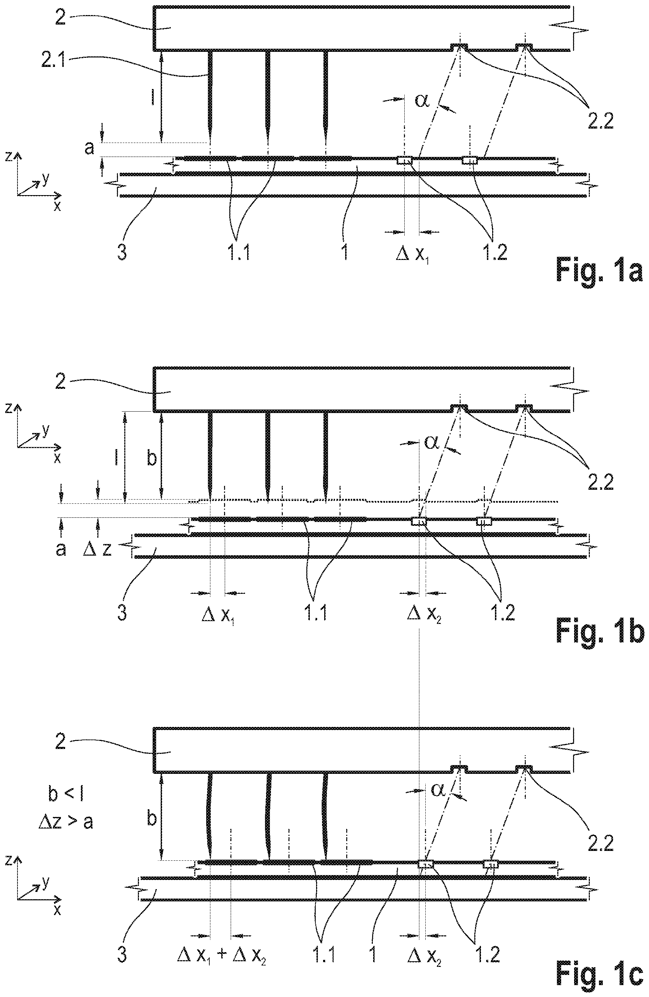

- Fig. 1a: einen Chip in einer ersten Justierlage (Nominalposition) zum Kontaktierungsmodul angeordnet,
- Fig. 1b: der Chip in einer zweiten Justierlage zum Kontaktierungsmodul angeordnet und
- Fig. 1c: der Chip in einer dritten Justierlage (Maximum-Position der optischen Kopplung) zum Kontaktierungsmodul angeordnet.

Mit einem erfindungsgemäßen Verfahren werden von auf einem Wafer angeordnete opto-elektronische Chips 1 mit elektrischen Schnittstellen in Form von Kontaktpads 1.1 und hierzu fest angeordnete optische Schnittstellen in Form von optischen Umlenkelementen 1.1, z.B. Gitterkopplern oder Spiegeln, mit einem spezifischen Kopplungswinkel α getestet. Der spezifische Kopplungswinkel α stellt einen Winkel dar, den ein optisches Signal bzw. dessen Hauptstrahl mit einem Lot auf den Chip 1 einschließt. Er ist typischerweise größer 0° und kleiner 25°. Ein gängiger Wert für den spezifischen Koppelungswinkel α liegt z.B. bei 11,6° und bezieht sich auf die zur Kopplung in der Endanwendung des Chips verwendeten Glasfasern mit entsprechendem Keilanschliff.

Dabei wird gleich einem Verfahren des Standes der Technik ein Wafer von einem in x -, y - und z- Richtung eines kartesischen Koordinatensystems gegenüber einem Kontaktierungsmodul 2, verstellbaren und um die z Achse drehbaren Positioniertisch 3 aufgenommen. Das Kontaktierungsmodul 2 verfügt neben über zu den Chips 1 zuordenbaren elektrische Schnittstellen 2.1 auch über hierzu zuordenbaren optische Schnittstellen 2.2. Die elektrischen Schnittstellen und die optischen Schnittstellen der Chips 1 werden im Waferverbund mit unterschiedlichen Technologien und in unterschiedlichen Verfahrensschritten hergestellt, so dass sie jeweils untereinander zwar nur geringe Lagetoleranzen aufweisen, die durch die elektrischen Schnittstellen gebildete Anordnungen unterliegen jedoch gegenüber den durch die optischen Schnittstellen gebildete Anordnungen insbesondere bezogen auf verschiedene Wafer vergleichsweise großen Toleranzabweichungen.

In einem ersten Justierschritt, wird der Wafer dem Kontaktierungsmodul 2 so zugestellt, dass die an dem Kontaktierungsmodul 2 vorhandenen elektrischen Schnittstellen in Form von Nadeln 1.1, in eine erste Justierlage (Nominalposition), lotrecht oberhalb der Mittelpunkte der Kontaktpads 1.1 eines ersten der Chips 1 angeordnet werden. Während der Justierung weist der Kontaktierungsmodul in z-Richtung einen Justierabstand a auf, größer der freien Länge l der Nadeln 2.1 zu dem Chip 1, sodass es zu keinem Kontakt zwischen den Nadelspitzen der Nadeln 2.1 und den Kontaktpads 1.1 kommen kann. Siehe hierzu **Fig. 1a****,** wobei hier der Einfachheit halber, wie auch in den andren Figuren, auf die die Darstellung der Justierung in y-Richtung verzichtet wurde. Entsprechend sind Stellwege während einzelner Justierschritte nur als Stellwege in x-Richtung dargestellt.

Der Ablauf dieses ersten Justierschrittes erfolgt vorteilhaft gemäß einer aus der Praxis bekannten festen Routine. Dabei misst eine Kamera die Nadeln 2, durch Fokussierung auf die Nadelspitzen, und eine zweite Kamera misst die Kontaktpads 1.1 des Chips 1 ein. Beide Kameras sind vorher über ein Normal zueinander referenziert worden. Das ermöglicht anschließend die genaue Berechnung der optimalen Position (Nominalposition) der Nadeln 2 in Bezug auf die Kontaktpads 1.1 und damit die Positionierung des Kontaktmoduls 2 zum Chip 1. Meistens geschieht das über Regression und Extrapolation der Messwerte. Zudem wird zu jeder gefundenen Nadel 2 auch ein Kontaktpad 1.1 als Gegenstück erwartet. In diese Routine kann durch den Nutzer im Regelfall nicht eingegriffen werden. Auch können meist keine alternativen Strukturen wie Justiermarken etc. für die Positionierung verwendet werden. Über die Kameras wird nicht nur die x-y Position sowie eine Verdrehung um die z-Achse korrigiert, sondern auch die z-Position ermittelt.

Es ist dem Fachmann klar, dass aufgrund von Lagetoleranzen der Nadelspitzen zueinander und der Mittelpunkte der Kontaktpads 1.1 zueinander zeitgleich nicht wirklich alle Nadelspitzen exakt oberhalb der Mittelpunkte der Kontaktpads 1.1 angeordnet werden können und man letztendlich eine Position einjustiert in der die mittlere Abweichung am geringsten ist. Die Lagetoleranz der elektrischen Schnittstellen zueinander, ist jedoch vernachlässigbar klein im Vergleich zu der Lagetoleranz der Anordnung der elektrischen Schnittstellen zu der Anordnung der optischen Schnittstellen eines Chips 1, was seine Ursache insbesondere darin hat, dass die elektrischen Schnittstellen und die optischen Schnittstellen nacheinander mit unterschiedlichen Technologien hergestellt werden.

Da die Herstellung der elektrischen Schnittstellen bzw. die Herstellung der optischen Schnittstellen für alle Chips eines Wafers jeweils in einem Verfahrensablauf erfolgt ist die Lageabweichung zwischen den Anordnungen der elektrischen Schnittstellen und den Anordnungen der optischen Schnittstellen einzelner Chips eines Wafers wenigstens annähernd gleich.

Nachdem die Anordnung der elektrischen Kontakte des Chips 1 (Nadeln 2.1) zu den elektrischen Kontakten des Kontaktierungsmodul 2 (Kontaktpads 1) ausgerichtet ist, weicht die tatsächliche Position der optischen Schnittstellen des Chips zu den optischen Schnittstellen am Kontaktierungsmodul 2.2 aufgrund verschiedener Ursachen von einer Solllage ab, siehe **Fig. 1a****.**

So weicht erstens die Lage der optischen Schnittstellen am Chip 1 von ihrer Sollposition in x-, y-, z- und um die z-Richtung statistisch veränderlich bei jedem Wafer ab, während die Abweichungen um die x- und um die y-Richtung durch die Ausrichtung des Positioniertisches 3 nach erfolgter Lagefixierung des Chips 1 und damit des Wafers als unveränderlich angenommen werden können (systematische Abweichungen).

Zweitens gibt es eine Abweichung der Lage der optischen Schnittstellen am Kontaktierungsmodul 2.2 von einer Solllage in Bezug zu den Nadeln 2.1, abhängig von der Montagegenauigkeit des optischen Moduls, welches integraler Bestandteil des Kontaktierungsmoduls ist. Dies betrifft nicht nur Lageabweichungen in x-, y- und z-Richtung, sondern auch Verkippungen um die z-, sowie um die x- und um die y-Richtung. Es handelt sich bei allen 6 Parametern um montagebedingte, systematische Abweichungen.

Und drittens kommt es über die Lebensdauer des Kontaktierungsmoduls 2 zu veränderlichen Abweichungen. Der Grund dafür ist die mechanische Abnutzung und damit Formänderung der Nadelspitzen sowie mögliche Verbiegungen und der daraus resultierenden Änderung im Fitergebnis.

Über die Kameramessung korrigiert der Positioniertisch 3 de facto die Position des gesamten Kontaktierungsmoduls 2 zum Chip/Wafer entsprechend nach - und ändert damit auch aufgrund des spezifischen Kopplungswinkels des jeweiligen optischen Umlenkelementes, insbesondere eines Gitterkopplers, die Position der Anordnung der optischen Schnittstellen des Kontaktierungsmoduls 2.2 zu der Anordnung der optischen Schnittstellen am Chip 1.

In weiteren Justierschritten erfolgt jetzt die relative Ausrichtung der optischen Schnittstellen des ersten Chips 1 zu den an dem Kontaktierungsmodul vorhanden optischen Schnittstellen

Davon ausgehend, dass die Nadeln 2.1 als elektrische Schnittstellen am Kontaktierungsmodul 2 optimal zu den Mittelpunkten der Kontaktierungspads 1.1 als den elektrischen Schnittstellen am Chip 1 ausgerichtet sind, ist für die Justierung der optischen Schnittstellen des Chips 1 zu denen am Kontaktierungsmodul ein Spielraum gegeben, der durch die Größe der Kontaktpads 1.1 gegeben ist, da es für die elektrische Signalleitung ausreichend ist, dass ein mechanischer Kontakt zwischen der Nadelspitze und dem Kontaktpad besteht.

In einem ersten weiteren Justierschritt erfolgt die relative Ausrichtung der optischen Schnittstellen von Chip und Kontaktierungsmodul zueinander, indem in einem Scanfeld kleiner der Größe der Kontaktpads der Positioniertisch, gegenüber der ersten Justierlage in x- und y-Richtung in eine zweite Justierlage ausgelenkt wird (Rasterscan), wie in **Fig. 1b** durch den ersten Stellweg Δx1 dargestellt wurde. Während dessen wird über wenigstens eine der optischen Schnittstellen des Kontaktierungsmoduls und des ersten Chips ein optisches Signal geleitet. Die zweite Justierlage wurde eingenommen, wenn das optische Signal mit einer maximalen Intensität eingekoppelt wird. Siehe hierzu **Fig. 1b****.**

Anschließend wird der Positioniertisch in einem zweiten weiteren Justierschritt in x- und y- Richtung in eine dritte Justierlage ausgelenkt, wie in **Fig. 1c** durch den zweiten Stellweg Δx2 dargestellt wurde. Der Justierweg von der zweiten in die dritte Justierlage wird aus dem Zustellweg Δz und dem Kopplungswinkel α des betreffenden Gitterkopplers berechnet, bevor der Positioniertisch dem Kontaktierungsmodul in z-Richtung um den Zustellweg Δz in den optischen Arbeitsabstand b zugestellt wird, indem die Nadeln mit einer vorgegebenen konstanten Andruckkraft an den Kontaktpads anliegen. Das wird erreicht in dem der optische Arbeitsabstand kleiner der freien Länge der Nadeln l gewählt wird. Die Differenz wird als Overtravel oder auch Overdrive bezeichnet.

Mit dem Overtravel wird ein sicherer elektrischer Kontakt der Nadeln mit den Kontaktpads gewährleistet (geringer Kontaktwiderstand). Nach dem ersten leichten Kontakt der Nadeln mit den Kontaktpads wird der Wafer noch um einige 10µm in z-Richtung nach oben gefahren. Damit werden zwei Sachen erreicht. Einerseits wird damit ein Scratchen der Nadeln über das Kontaktpad forciert, wodurch die Oxidoberfläche durchbrochen und ein reproduzierbarer, niederohmiger Kontakt erreicht wird. Andererseits wird durch den Overtravel ein konstanter Anpressdruck der Nadeln erzeugt, da die Nadeln aufgrund des zusätzlichen Stellweges entsprechend einfedern und eine Andruckkraft auf das Kontaktpad ausüben. Diese Andruckkraft ist je nach verwendetem Nadeltyp unterschiedlich, man kann aber größenordnungsmäßig von ca. 3g pro Nadel ausgehen. Typischerweise wird der Overtravel in Vielfachen von MIL angegeben (amerik. 1mil = 1/1000 Zoll = 0,0254mm)

Bei einem Kontaktierungsmodul, bei dem die Anordnung der Nadel eine feste Lage zu den optischen Schnittstellen aufweist, muss der Wert des Overtravels bei der finalen Justierung des Chips berücksichtigt werden, sodass im kontaktierten Zustand sichergestellt wird, dass ein optischer Arbeitsabstand zwischen den optischen Schnittstellen des Kontaktierungsmoduls und dem Chip gegeben ist, beim dem eine maximale Einkopplung der optischen Signale gegeben ist.

Um den optischen Arbeitsabstand b einzustellen wird der Chip in die dritte Justierlage gebracht. In dieser ist der finale Justierzustand hergestellt, in dem sowohl die elektrischen als auch die optischen Schnittstellen von Chip und Kontaktierungsmodul bestmöglich zueinander ausgerichtet sind, das heißt eine bestmögliche Messfähigkeit der optischen Signalflüsse gegeben ist (Maximum-Position der optischen Kopplung), wobei auch der elektrische Signalfluss gegeben ist. Zur Prüfung des Chips werden anschließend über die jeweils einander zugeordneten Schnittstellen elektrische bzw. optische Signale geleitet.

Der Justierweg von der ersten Justierlage (Nominalposition) in die dritte Justierlage ((Maximum-Position der optischen Kopplung) stellt einen Versatz (Offset) dar (in Fig. 1c, als Δx1 +Δx2 , und Δz dargestellt) der vorteilhaft gespeichert wird und bei der Einjustierung aller weiteren Chips auf diesem Wafer mitberücksichtigt wird. D.h. die Nominalposition des Positioniertisches wird um diesen Versatz korrigiert. Das setzt jedoch eine entsprechend Verschiebung der Nadeln über den Kontaktpads voraus, die noch tolerierbar ist.

Diese Prozedur muss nur einmal pro Wafer oder auch in noch größeren Abständen durchgeführt werden.

Zudem kann dieser Versatzwert (Offset-Wert) und seine Änderungen über die Zeit beobachtet werden und lässt damit Aussagen über die Abnutzung und damit verbundene Veränderung der Nadeln zu.

Zu Erhöhung der Genauigkeit der Bestimmung des Versatzes kann der Rasterscan auch an mehreren Chips des Wafers vor Beginn der Prüfung aller Chips des Wafers durchgeführt und die Ergebnisse gemittelt werden.

Der benötigte Overtravel kann sich über die Lebensdauer des Kontaktierungsmoduls aufgrund eines "Einlaufens" oder durch Abnutzung der Nadeln ändern, womit sind der Arbeitsabstand verringert.

Die direkte Überwachung des optischen Arbeitsabstandes ist wichtig, um die definierten optischen Kopplungseigenschaften zwischen dem Kontaktierungsmodul und dem Chip zu gewährleisten (Messfähigkeit) und Kollisionen der optischen Schnittstellen von Kontaktierungsmodul und Chips zu verhindern (wenige 10-100µm Abstand im Betrieb).

Dafür kann ein fest im Kontaktierungsmodul integrierter Abstandssensor verwendet werden, z.B. ein kapazitiver Abstandssensor. Dieser ermöglicht eine Kontrolle des realen optischen Arbeitsabstandes. In Kombination mit einer aktiven Regelung kann der Arbeitsabstand durch Verfahren des Positioniertisches in z-Richtung aktiv nachgeregelt werden und bei Bedarf ein Hard Stop für die Unterschreitung eines Mindestarbeitsabstandes einprogrammiert werden, z.B. um eine Kollision durch Fehlbedienung des Operators zu vermeiden.

Typischerweise ist eine Veränderung der Nadelspitzenpositionen bei der Erstinbetriebnahme des Kontaktierungsmoduls zu erwarten (Einlaufverhalten). Dies kann durch eine mehrfache Kontaktsimulation vor der Einjustierung eines ersten Chips vorweggenommen werden (Voraltern), womit der Wert des einzustellenden Versatzes reduziert werden kann.

Üblicherweise weisen alle optischen Schnittstellen der Chips, verkörpert durch Gitterkoppler, Kopplungswinkel mit einem gleichen Winkelbetrag und einer gleichen Ausrichtung auf, so dass sich aus einer Änderung des optischen Arbeitsabstandes Δb entsprechend eine gleiche relative Änderung ΔX der optimalen Koppelposition für alle optischen Schnittstellen ergibt.

Typischerweise liegt die Änderung des optischen Arbeitsabstandes Δb im Bereich <50µm. Bei einer Änderung des optischen Arbeitsabstandes von beispielsweise 10µm und einem Kopplungswinkel α von 11.6° in der x-z-Ebene ergäbe sich damit in x-Richtung eine Änderung der optimalen Koppelposition ΔX von 2µm. Bei einer Änderung des optischen Arbeitsabstandes Δb von 20µm ergäbe sich in x-Richtung eine Änderung der optimalen Koppelposition ein ΔX von 4µm. Dies kann durch die oben beschriebene Korrektur noch abgefangen werden, d.h. der Positioniertisch wird in x-Richtung per Steuerbefehl unter der Annahme nachkorrigiert, dass die Nadeln immer noch ausreichend sicher auf die Kontaktpads treffen.

Die Anforderungen an die Genauigkeit der Justierschritte kann reduziert werden, wenn die zur Prüfung des Chips über die jeweils einander zugeordneten Schnittstellen geleiteten optische Signale die einkoppelnde Schnittstelle jeweils überstrahlen.

Vorteilhaft weisen die optischen Signale beim Auftreffen auf die einkoppelnde Schnittstelle eine Tophat-Verteilung ihrer Strahlungsintensität auf.

### Bezugszeichenliste

- 1: Chip
- 1.1: Kontaktpad
- 1.2: optisches Umlenkelement
- 2: Kontaktierungsmodul
- 2.1: Nadel
- 2.2: optische Schnittstelle am Kontaktierungsmodul
- 3: Positioniertisch
- Δz: Zustellweg
- α: Kopplungswinkel
- a: Justierabstand
- b: optischer Arbeitsabstand
- l: freie Länge der Nadel
- Δx₁: erster Stellweg
- Δx₂: zweiter Stellweg

## Patentansprüche

1. Verfahren zum Testen von auf einem Wafer angeordneten opto-elektronischen Chips (1), mit elektrischen Schnittstellen in Form von Kontaktpads (1.1) und hierzu fest angeordneten optischen Schnittstellen in Form von optischen Umlenkelementen (1.2), mit einem spezifischen Kopplungswinkel (α),
bei dem der Wafer von einem Positioniertisch (3) aufgenommen wird, der in x -, y- und z- Richtung eines kartesischen Koordinatensystems gegenüber einem Kontaktierungsmodul (2) verstellbar und um die z-Achse drehbar ist, wobei das Kontaktierungsmodul (2) den Kontaktpads (1.1) zugeordnete elektrische Schnittstellen in Form von Nadeln (2.1) und den optischen Umlenkelementen (1.2) zugeordnete optische Schnittstellen (2.2) aufweist, und
in einem ersten Justierschritt der Wafer dem Kontaktierungsmodul (2) so zugestellt wird, dass die Nadeln (2.1), in einer ersten Justierlage, lotrecht oberhalb der Mittelpunkte der Kontaktpads (1.1) eines ersten der Chips (1) angeordnet sind, wobei das Kontaktierungsmodul (2) in z-Richtung einen Justierabstand (a) größer einer freien Länge (I) der Nadeln (2.1) zu dem ersten der Chips (1) aufweist,
in weiteren Justierschritten die relative Ausrichtung der optischen Umlenkelemente (1.2) zu den an dem Kontaktierungsmodul (2) vorhandenen optischen Schnittstellen (2.2) erfolgt,
dann der Positioniertisch (3) dem Kontaktierungsmodul (2) in z-Richtung um einen Zustellweg (Δz) in einen optischen Arbeitsabstand (b) zugestellt wird, bei dem die Nadeln (2.1) mit einer vorgegebenen Andruckkraft an den Kontaktpads (1.1) anliegen, und
anschließend über die jeweils einander zugeordneten Schnittstellen elektrische bzw. optische Signale geleitet werden, **dadurch gekennzeichnet,**
**dass** die relative Ausrichtung der optischen Umlenkelemente (1.2) zu den an dem Kontaktierungsmodul (2) vorhandenen optischen Schnittstellen (2.2) erfolgt, indem in einem Scanfeld kleiner der Größe der Kontaktpads (1.1) zuerst der Positioniertisch (3) gegenüber der ersten Justierlage in x- und y-Richtung in eine zweite Justierlage ausgelenkt wird, während über wenigstens eine der optischen Schnittstellen des Kontaktierungsmoduls (2.2) und eine der optischen Umlenkelemente (1.2) ein optisches Signal geleitet wird, wobei die zweite Justierlage eingenommen ist, wenn das optische Signal mit einer maximalen Intensität eingekoppelt wird, und
anschließend der erste der Chips (1) über einen Stellweg in eine dritte Justierlage in x-y- Richtung ausgelenkt wird, wobei der Stellweg aus dem Zustellweg (Δz) und dem Kopplungswinkel (α) des betreffenden optischen Umlenkelementes (1.2) berechnet wurde, bevor der Positioniertisch (3) dem Kontaktierungsmodul (2) in z-Richtung um den Zustellweg (Δz) in den optischen Arbeitsabstand (b) zugestellt wird.

2. Verfahren zum Testen von auf einem Wafer angeordneten opto-elektronischen Chips (1) nach Anspruch 1, **dadurch gekennzeichnet,**
**dass** eine sich aus der ersten Justierlage und der zweiten Justierlage des ersten der Chips (1) ergebende Lagedifferenz als Offset abgespeichert wird und für die Justierung weiterer der Chips (1) berücksichtigt wird, nachdem diese in einer ersten Justierlage zum Kontaktierungsmodul (2) positioniert wurden.

3. Verfahren zum Testen von auf einem Wafer angeordneten opto-elektronischen Chips (1) nach Anspruch 1 oder 2, **dadurch gekennzeichnet,**
**dass** der optische Arbeitsabstand (b), bei dem die Nadeln (2.1) mit einer vorgegebenen Andruckkraft an den Kontaktpads (1.1) anliegen, überwacht wird und bei Änderungen der Andruckkraft die dritte Justierlage korrigiert wird.

4. Verfahren zum Testen von auf einem Wafer angeordneten opto-elektronischen Chips (1) nach einem der Ansprüche 1 bis 3, **dadurch gekennzeichnet,**
**dass** die Änderung des optischen Arbeitsabstandes (b) langfristig über die Einsatzdauer des Kontaktierungsmoduls (2) ermittelt wird und für die Verfahrensdurchführung die Nadeln (2.1) des Kontaktierungsmoduls (2) gegen neue Nadeln (2.1) ersetzt werden, wenn der optische Arbeitsabstand (b) einen vorgegebenen Minimalabstand unterschreitet.

5. Verfahren zum Testen von auf einem Wafer angeordneten opto-elektronischen Chips (1) nach einem der Ansprüche 1 oder 2, **dadurch gekennzeichnet,**
**dass** die über die jeweils einander zugeordneten Schnittstellen geleiteten optischen Signale beim Einkoppeln in einer der Schnittstellen diese überstrahlen.

6. Verfahren zum Testen von auf einem Wafer angeordneten opto-elektronischen Chips (1) nach einem der Ansprüche 1 oder 2, **dadurch gekennzeichnet,**
**dass** die über die jeweils einander zugeordneten Schnittstellen geleiteten optischen Signale beim Einkoppeln in eine der Schnittstellen eine Tophat-Verteilung ihrer Strahlungsintensität aufweisen.

## Claims

1. A method for testing optoelectronic chips (1) arranged on a wafer, with electrical interfaces in the form of contact pads (1.1) and optical interfaces fixed relative thereto in the form of optical deflection elements (1.2), with a specific coupling angle (α),
wherein the wafer is received by a positioning table (3) which is adjustable in the x, y and z-directions of a Cartesian coordinate system relative to a contacting module (2) and rotatable about the z-axis, the contacting module (2) having electrical interfaces in the form of needles (2.1) assigned to the contact pads (1.1) and optical interfaces (2.2) assigned to the optical deflecting elements (1.2), and
in a first adjustment step, the wafer is fed to the contacting module (2) in such a way that the needles (2.1), in a first adjustment position, are arranged vertically above the centres of the contact pads (1.1) of a first one of the chips (1), the contacting module (2) having an adjustment distance (a) greater than a free length (l) of the needles (2.1) from the first one of the chips (1) in the z-direction,
the relative alignment of the optical deflection elements (1.2) to the optical interfaces (2.2) present on the contacting module (2) is carried out in further adjustment steps,
then the positioning table (3) is moved towards the contacting module (2) in the z-direction by a feed path (Δz) to an optical working distance (b) at which the needles (2.1) contact the contact pads (1.1) with a predetermined contact pressure force, and
electrical or optical signals are then transmitted via the respective interfaces assigned to one another, **characterized in that**
the relative alignment of the optical deflection elements (1.2) to the optical interfaces (2.2) present on the contacting module (2) is performed by first deflecting the positioning table (3), in a scan field smaller than the size of the contact pads (1. 1), relative to the first alignment position in the x and y directions into a second alignment position, while an optical signal is conducted via at least one of the optical interfaces of the contacting module (2.2) and one of the optical deflection elements (1.2), the second alignment position being assumed when the optical signal is coupled in with a maximum intensity, and
the first of the chips (1) is then deflected over an adjustment path into a third adjustment position in the x-y direction, the adjustment path having been calculated from the feed path (Δz) and the coupling angle (α) of the relevant optical deflection element (1.2), before the positioning table (3) is fed to the contacting module (2) in the z direction by the feed path (Δz) to the optical working distance (b).

2. The method for testing optoelectronic chips (1) arranged on a wafer according to claim 1, **characterized in that**
a position difference resulting from the first adjustment position and the second adjustment position of the first of the chips (1) is stored as an offset and is taken into account for the adjustment of further chips (1) after these have been positioned in a first adjustment position relative to the contacting module (2).

3. The method for testing optoelectronic chips (1) arranged on a wafer according to claim 1 or 2, **characterized in that** the optical working distance (b), at which the needles (2.1) contact the contact pads (1.1) with a predetermined contact pressure force, is monitored and the third adjustment position is corrected in the event of changes in the contact pressure force.

4. The method for testing optoelectronic chips (1) arranged on a wafer according to any one of claims 1 to 3, **characterized in that**
the change in the optical working distance (b) is determined in the long term over the period of use of the contacting module (2) and the needles (2.1) of the contacting module (2) are replaced with new needles (2.1) for carrying out the process if the optical working distance (b) falls below a predetermined minimum distance.

5. The method for testing optoelectronic chips (1) arranged on a wafer according to any one of claims 1 or 2, **characterized in that**, when coupled into one of the interfaces, the optical signals conducted via the respective interfaces assigned to one another radiate beyond these.

6. The method for testing opto-electronic chips (1) arranged on a wafer according to one of claims 1 or 2, **characterized in that** the optical signals conducted via the respective interfaces assigned to one another have a top hat distribution of their radiation intensity when coupled into one of the interfaces.

## Revendications

1. Procédé de test pour des puces optoélectroniques (1) disposées sur une tranche, avec des interfaces électriques sous forme de pastilles de contact (1.1) et des interfaces optiques disposées de manière fixe par rapport à celles-ci sous forme d'éléments de renvoi optiques (1.2), avec un angle de couplage spécifique (α),
dans lequel la tranche est reçue par une table de positionnement (3) qui peut être déplacée dans les directions x, y et z d'un système de coordonnées cartésiennes par rapport à un module de mise en contact (2) et qui peut tourner autour de l'axe z, le module de mise en contact (2) présentant des interfaces électriques sous forme d'aiguilles (2.1) associées aux pastilles de contact (1.1) et des interfaces optiques (2.2) associées aux éléments de renvoi optiques (1.2), et
dans une première étape d'ajustement, la tranche est approchée du module de mise en contact (2) de telle sorte que les aiguilles (2.1), dans une première position d'ajustement, sont disposées verticalement au-dessus des points centraux des pastilles de contact (1.1) d'une première des puces (1), le module de mise en contact (2) présentant dans la direction z une distance d'ajustement (a) supérieure à une longueur libre (l) des aiguilles (2.1) par rapport à la première des puces (1),
l'alignement relatif des éléments de renvoi optiques (1.2) par rapport aux interfaces optiques (2.2) présentes sur le module de mise en contact (2) est effectué au cours d'autres étapes d'ajustement,
puis la table de positionnement (3) est approchée du module de mise en contact (2) dans la direction z d'une distance d'approche (Δz) à une distance de travail optique (b) à laquelle les aiguilles (2.1) s'appliquent contre les pastilles de contact (1.1) avec une force de pression prédéterminée, et
ensuite, des signaux électriques ou optiques sont acheminés via les interfaces respectivement associées les unes aux autres, **caractérisé en ce que** l'alignement relatif des éléments de renvoi optiques (1.2) par rapport aux interfaces optiques (2.2) présentes sur le module de mise en contact (2) s'effectue **en ce que**, dans un champ de balayage inférieur à la taille des pastilles de contact (1.1), la table de positionnement (3) est d'abord déviée par rapport à la première position d'ajustement dans les directions x et y dans une deuxième position d'ajustement, et en même temps un signal optique est transmis via au moins l'une des interfaces optiques du module de mise en contact (2.2) et l'un des éléments de renvoi optiques (1.2), la deuxième position d'ajustement étant prise lorsque le signal optique est couplé avec une intensité maximale, et
ensuite, la première des puces (1) est déviée sur une course de positionnement dans une troisième position d'ajustement dans la direction x-y, la course de positionnement ayant été calculée à partir de la distance d'approche (Δz) et de l'angle de couplage (α) de l'élément de renvoi optique (1.2) concerné, avant que la table de positionnement (3) ne soit approchée du module de mise en contact (2) dans la direction z sur la distance d'approche (Δz) dans la distance de travail optique (b).

2. Procédé de test pour des puces optoélectroniques (1) disposées sur une tranche selon la revendication 1, **caractérisé en ce**
**qu'**une différence de position résultant de la première position d'ajustage et de la deuxième position d'ajustage de la première des puces (1) est mémorisée comme offset et est prise en compte pour l'ajustage d'autres puces (1) après que celles-ci ont été positionnées dans une première position d'ajustage par rapport au module de mise en contact (2).

3. Procédé de test pour des puces optoélectroniques (1) disposées sur une tranche selon la revendication 1 ou 2, **caractérisé en ce qu'**on surveille la distance de travail optique (b) à laquelle les aiguilles (2.1) s'appliquent contre les pastilles de contact (1.1) avec une force de pression prédéterminée, et on corrige la troisième position d'ajustement en cas de modification de la force de pression.

4. Procédé de test pour des puces optoélectroniques (1) disposées sur une tranche selon l'une quelconque des revendications 1 à 3, **caractérisé en ce**
**que** la modification de la distance de travail optique (b) est déterminée à long terme sur la durée d'utilisation du module de mise en contact (2) et que, pour la mise en œuvre du procédé, les aiguilles (2.1) du module de mise en contact (2) sont remplacées par de nouvelles aiguilles (2.1) lorsque la distance de travail optique (b) est inférieure à une distance minimale prédéfinie.

5. Procédé de test pour des puces optoélectroniques (1) disposées sur une tranche selon l'une quelconque des revendications 1 ou 2, **caractérisé en ce que** les signaux optiques acheminés par les interfaces respectivement associées les unes aux autres, lorsqu'ils sont couplés dans l'une des interfaces, rayonnent au-delà de celle-ci.

6. Procédé de test pour des puces optoélectroniques (1) disposées sur une tranche selon l'une quelconque des revendications 1 ou 2, **caractérisé en ce que** les signaux optiques acheminés par l'intermédiaire des interfaces respectivement associées les unes aux autres présentent, lorsqu'ils sont couplés dans l'une des interfaces, une répartition top-hat de leur intensité de rayonnement.
